# EUROPEAN PATENT SPECIFICATION

(11) **EP 0 449 128 B1**
(45) Date of publication and mention of the grant of the patent: **28.02.1996**
(21) Application number: 91104504.5
(22) Date of filing: 22.03.1991
(51) Int. Cl.: H01L 39/24

(54) **Substrate material for the preparation of oxide superconductors**
Substrat-Material zur Herstellung von Oxydsupraleitern
Matériau de substrat pour la préparation d'oxydes supraconducteurs

(30) Priority: 28.03.1990 JP 82498/90
(43) Date of publication of application: 02.10.1991
(73) Proprietor: INTERNATIONAL SUPERCONDUCTIVITY TECHNOLOGY CENTER, Tokyo (JP); MITSUBISHI JUKOGYO KABUSHIKI KAISHA, Tokyo (JP); FUJIKURA LTD., Koto-ku Tokyo (JP); NIPPON STEEL CORPORATION, Tokyo 100 (JP)
(72) Inventor: Oishi, Akira, Superconductivity Res. Lab., 1-chome, Koto-ku, Tokyo (JP); Usui, Toshio, Superconductivity Res. Lab., 1-chome, Koto-ku, Tokyo (JP); Teshima, Hidekazu, c/o Superconductivity Res. Lab., 1-chome, Koto-ku, Tokyo (JP); Morishita, Tadataka, Superconductivity Res. Lab., 1-chome, Koto-ku, Tokyo (JP)
(74) Representative: Dr. Fuchs, Dr. Luderschmidt Dr. Mehler, Dipl.-Ing. Weiss Patentanwälte

(56) References cited:
- EP-A- 0 345 441
- WO-A-90/04857
- DE-A- 3 906 499
- Physica C, Vol. 162-164, 1989, pp. 703-704, R.H. Hammond et al.
- Appl. Phys. Lett., Vol. 55, No. 21, 20 November 1989, pp. 2230-2232, S. Miyazawa
- J. Mater. Res., Vol. 5, No. 1, January 1990, pp. 183-189. H.M. O'Bryan et al.
- Appl. Phys. Lett., Vol. 52, No. 24, 13 June 1988, pp. 2068-2070, A. Mogro-Campero et al.

## Description

### Background of the Invention

The present invention relates to a substrate material for preparing an oxide superconductor thereon, a substrate for preparing a semiconductor thereon, a substrate for preparing an oxide superconductor thereon comprising a semiconductor substrate and an intermediate layer of a mixed crystal material formed on said semiconductor substrate and a substrate for preparing a semiconductor thereon comprising an oxide superconductor substrate and an intermediate layer of a mixed crystal material formed on said oxide superconductor substrate.

The present invention relates to techniques useful when applied to the field of electronics including devices using Josephson junction as well as that of electric power including power storage and power transmission.

Various methods have been known for the manufacture of oxide superconductors, including a method of depositing a film using epitaxial growth of an oxide superconductor on a substrate. Also, various methods are known for forming films, such as molecular beam epitaxy (abbreviated as M.B.E.) and high-frequency sputtering. An atmosphere in which a film is formed almost always includes oxygen. When a film of an oxide superconductor is formed according to these methods, a substrate material is required that does not react with the oxide superconductor. As substrate materials satisfying this condition, MgO, ZrO₂, MgAl₂O₄, LaAlO₃, SrTiO₃, LaGaO_{3,} etc. are used. These materials are less reactive with oxide superconductors than Si or Al₂O₃.

However, according to studies having been done so far in the field of superconductivity, it is known that substrate materials such as SrTiO₃ and LaGaO₃ show superior superconducting characteristics compared to MgO, ZrO₂, MgAl₂O₄, or LaAlO₃ when they are used in devices.

Table 1 shows the lattice constants of the substrate materials and the oxide superconductors mentioned above, and Si and GaAs. In Table 1, the values of lattice constants of SrTiO₃ and YBa₂Cu₃O_{y} (y being approximately 7) shown with the "*" mark attached are those multiplied by the square root of 2 so as to emphasize lattice mismatching. As readily seen from Table 1, SrTiO₃, LaGaO₃ and the like have smaller mismatching of lattice constants with the oxide superconductors. The smaller the differences are in lattice constants between the substrate materials and the oxide superconductors, the easier the epitaxial growth becomes, so as to make it easy to obtain an oxide superconductor film of single crystal and thus improve the superconducting characteristics of the oxide superconductors in a film form.

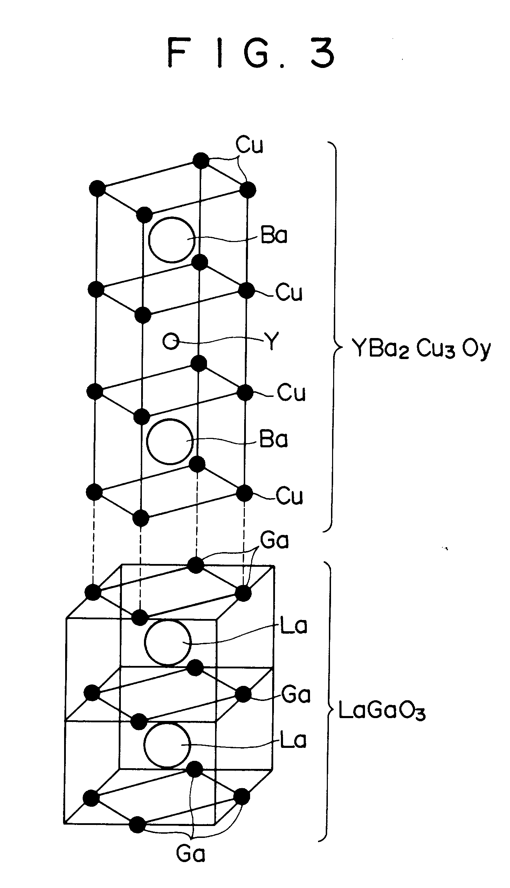

As materials having smaller mismatching with oxide superconductors, perovskite-type compounds such as LaGaO₃ have been used. FIG. 3 shows the unit crystal structure of LaGaO₃ and an oxide superconductor YBa₂Cu₃O_{y}. It should be noted that oxygen is not shown in FIG. 3. As shown in FIG. 3, many compounds of perovskite type are known to have lattice constants close to a multiple of the lattice constants of oxide superconductors or to 2n times the multiple (n being an integer).

From EP 0 345 441 A2 it is known that high T_{c} superconductive structures can be formed on gallate layers where the gallate layers include a rare earth element or a rare earth-like element.

From DE 39 06 499 A1 superconducting film material on mono-crystal lanthanum orthogallate substrate can be gathered.

The inventors of the present invention have studied the state of prior art described above and found the following problems.

The lattice constants of an oxide superconductor film prepared by M.B.E. or high-frequency sputtering described above vary depending on the concentration of oxygen in the atmosphere during film formation or in a cooling process.

Also, the temperature during the formation of an oxide superconductor film by M.B.E. or high-frequency sputtering is normally as high as 600°C to 800°C. Therefore, there exits mismatching between a substrate material and an oxide superconductor caused by differences in the thermal expansion of the materials. As a result, because of the mismatching due to thermal expansion as well as that due to differences in the lattice constants, an oxide superconductor with superior superconducting characteristics cannot be obtained when the conventional substrate materials described above are used.

Furthermore, in order to obtain a device in which oxide superconductor and semiconductor elements coexist, an oxide superconductor film has to be prepared on, for example, an Si substrate. However, when a film of an oxide superconductor is prepared by the M.B.E. or the high-frequency sputtering mentioned above, because the temperature of film formation is high, the oxide superconductor and the Si substrate react with each other, and the superconducting characteristics of the oxide superconductor may never materialize.

According to Appl. Phys. Lett, Vol.52, No.24, June 1988, page 2068 a zirconia buffer layer formed using ZrO₂ is to prevent strong interface reactions and interdiffusion between semiconductor and YBaCuO, and results in an unoriented polycrystalline YBaCuO film. In this document the zirconia buffer layer is a simple diffusion barrier.

### BRIEF SUMMARY OF THE INVENTION

The present invention has been made to solve the above-mentioned problems.

An object of the present invention is, in respect of a substrate material used in the preparation of an oxide superconductor, to provide a technology which makes it possible to improve the superconducting characteristics of an oxide superconductor prepared on such a substrate material.

Another object of the present invention is, in respect of preparing a semiconductor on a substrate material, to provide a technology which makes it possible to prepare a good semiconductor on the substrate material.

Still another object of the present invention is, in respect of preparing a semiconductor on an oxide superconductor with an intermediate layer between them, to provide a technology which makes it possible to improve the superconducting characteristics of the oxide superconductor.

Yet another object of the present invention is, in respect of preparing a semiconductor on an oxide superconductor with an intermediate layer between them, to provide a technology which makes it possible to prepare a good semiconductor on the intermediate layer.

The above-mentioned objects and other objects as well as the novel characteristics of the present invention will be made clear by the disclosure of this specification and the attached drawings.

In order to achieve the objects described above, the substrate material for the preparation of an oxide superconductor of the present invention is characterized in that said substrate material is expressed by the chemical formula La₁₋ₓNdₓGaO₃ wherein x is equal to or more than 0.3 and less than 1.0 and which is a mixed crystal forming a perovskite-type structure having a composition of AGaO₃ where A is either Nd or La. The oxide superconductor film may be either thick or thin.

The present invention is also characterized by the preparation of a semiconductor on said substrate material.

In addition, the present inventions characterized by the formation of an intermediate layer of a mixed crystal material which is expressed by the chemical formula La₁₋ₓNdₓGaO₃ wherein x is equal to or more than 0.3 and less than 1.0 and which is a mixed crystal forming a perovskite-type structure having a composition of AGaO₃ where A is either Nd or La.

Furthermore, the present invention is characterized by the formation of an intermediate layer of a mixed crystal material which is expressed by the chemical formula La₁₋ₓNdₓGaO₃ wherein x is equal to or more than 0.3 and less than 1.0 and which is a mixed crystal forming a perovskite-type structure having a composition of AGaO₃ where A is either Nd or La, and by the preparation of a semiconductor on the intermediate layer.

The inventive substrate for preparing an oxide superconductor thereon comprising a semiconductor substrate and an intermediate layer of a mixed crystal material formed on said semiconductor substrate, is characterized in that said mixed crystal material is expressed by the chemical formula La₁₋ₓNdₓGaO₃ wherein x is equal to or more than 0.3 and less thanl.0 and which is a mixed crystal forming a perovskite-type structure having a composition of AGaO₃ where A is either Nd or La. The inventive substrate for preparing a semiconductor thereon comprising an oxide superconductor substrate and an intermediate layer of a mixed crystal material formed on said oxide superconductor substrate, characterized in that said mixed crystal material is the substrate material as mentioned above.

According to these characteristics of the present invention as summarized above, because it appears that the rare earth elements in the IIIa group at the La sites in FIG. 3 have similar characters and can be replaced by a different rare earth element in the IIIa group with a different ionic radius, a substrate material with differing lattice constants can be obtained while maintaining its crystal structure. Therefore, the lattice constants which are normally inherent to a material can be varied artificially so as to reduce the mismatching between an oxide superconductor and a substrate material due to differences among their lattice constants and improve the superconducting characteristics of an oxide superconductor.

Also, it is possible to choose the lattice constants of a substrate material for the preparation of an oxide superconductor while taking thermal expansion into consideration so as to reduce mismatching between an oxide superconductor and a substrate material even under the high temperature conditions for the formation of an oxide superconductor film by M.B.E. or by high-frequency sputtering. Thus an oxide superconductor with superior superconducting characteristics can be prepared.

Further, because certain multiples of the lattice constants of a unit cell of the substrate materials or the multiple times the square root of 2 are close to the lattice constants of Si and GaAs, by forming an insulator substrate for silicon on insulator (abbreviated as S.O.I.) using the substrate material mentioned above, a good film of Si or GaAs can be formed on the insulator layer.

In addition, by forming an intermediate layer of the above-described substrate material between an oxide superconductor and an Si or GaAs substrate, the superconducting characteristics of the oxide superconductor prepared on the intermediate layer can be improved.

Also, because the substrate material exists between an oxide superconductor and a semiconductor substrate, even under the high temperature conditions for the formation of an oxide superconductor film by M.B.E. or by high-frequency sputtering, the oxide superconductor film and the Si substrate will not react with each other, and the resulting oxide superconductor on the substrate material will have superior superconducting characteristics.

Furthermore, using the above-described substrate material for the intermediate layer between an oxide superconductor and a semiconductor, it is possible to prepare a good semiconductor on the intermediate layer.

Also, because there exists the intermediate layer between an oxide superconductor and a semiconductor, the oxide superconductor and the semiconductor do not react with each other, and a good semiconductor can be prepared on the above-mentioned intermediate layer.

### BRIEF DESCRIPTION OF THE DRAWINGS

The invention will now be described in detail with reference to the accompanying drawings, wherein:
FIG. 1 is a graphical showing of powder x-ray diffraction patterns for the substrate material of La_{0.7}Nd_{0.3}GaO₃ for the preparation of an oxide superconductor and the oxide superconductor of YBa₂Cu₃O_{y} in embodiment 1 of the invention;
FIG. 2 is a graphical showing of x-ray diffraction patterns of a powder mixture of the substrate material La_{0.7}Nd_{0.3}GaO₃ and the oxide superconductor YBa₂Cu₃O_{y} before and after heating; and
FIG. 3 is a diagram of a unit crystal structure of the oxide superconductor YBa₂Cu₃O_{y} and the perovskite-type compound LaGaO₃.

### DETAILED DESCRIPTION OF PREFERRED EMBODIMENT

In describing the embodiment, the same reference numerals will be used for parts with the same function to omit repetition of describing numerals.

### Embodiment 1

First, as a double oxide which is an ingredient for an oxide superconductor substrate, a mixed crystal material of La₁₋ₓNdₓGaO₃ was prepared by powder mixing. In the preparation of this La₁₋ₓNdₓGaO₃ mixed crystal material, La₂O₃, Nd₂O₃ and Ga₂O₃ were used as ingredients.

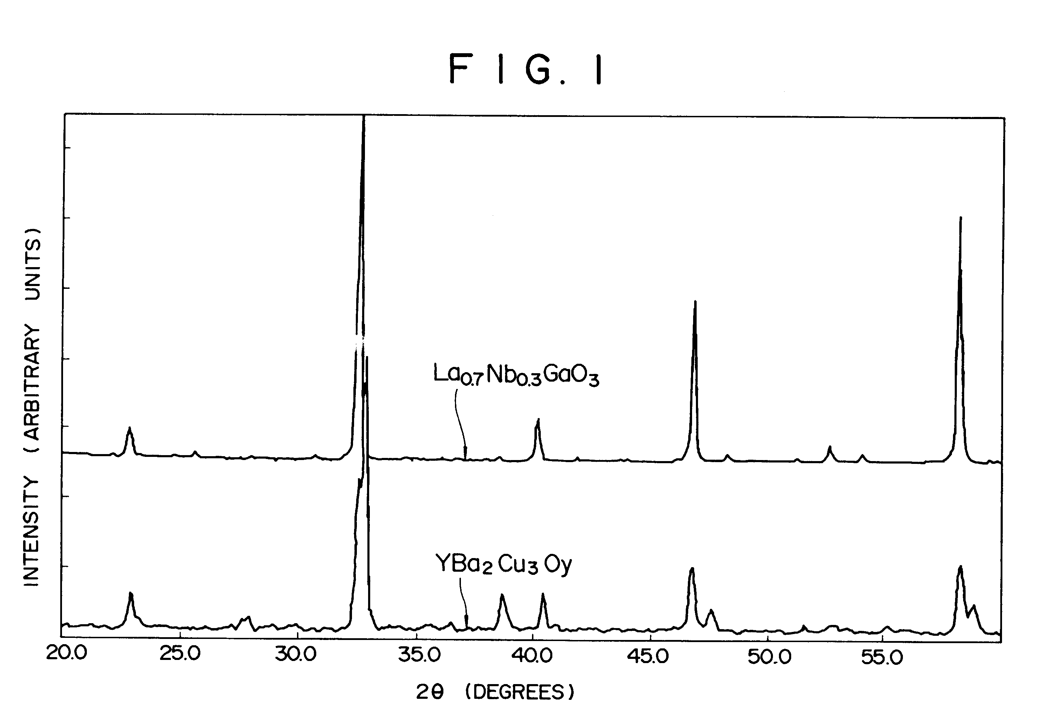

Next, the mixed crystal powder of La₁₋ₓNdₓGaO₃ prepared as described above and an oxide superconductor powder of YBaCuO type were mixed with each other at a weight ratio of 1 to 1, and the reactivity between the La₁₋ₓNdₓGaO₃ mixed crystal powder and the YBaCuO oxide superconductor powder was evaluated under high temperatures. This oxide superconductor of YBaCuO type can be, for example, YBa₂Cu₃O_{y} (y being approximately 7), YBa₂Cu₄O_{w} (w being approximately 8), LnBa₂Cu₃O_{y} (Ln being Nd, Pm, Gd, Dy, Ho, Er, Tm, or the like), or the like. FIG. 1 shows a powder x-ray diffraction pattern for each of YBa₂Cu₃O_{y} and La_{0.7}Nd_{0.3}GaO₃, which are examples of the above-described mixed crystal powder of La₁₋ₓNdₓGaO₃.

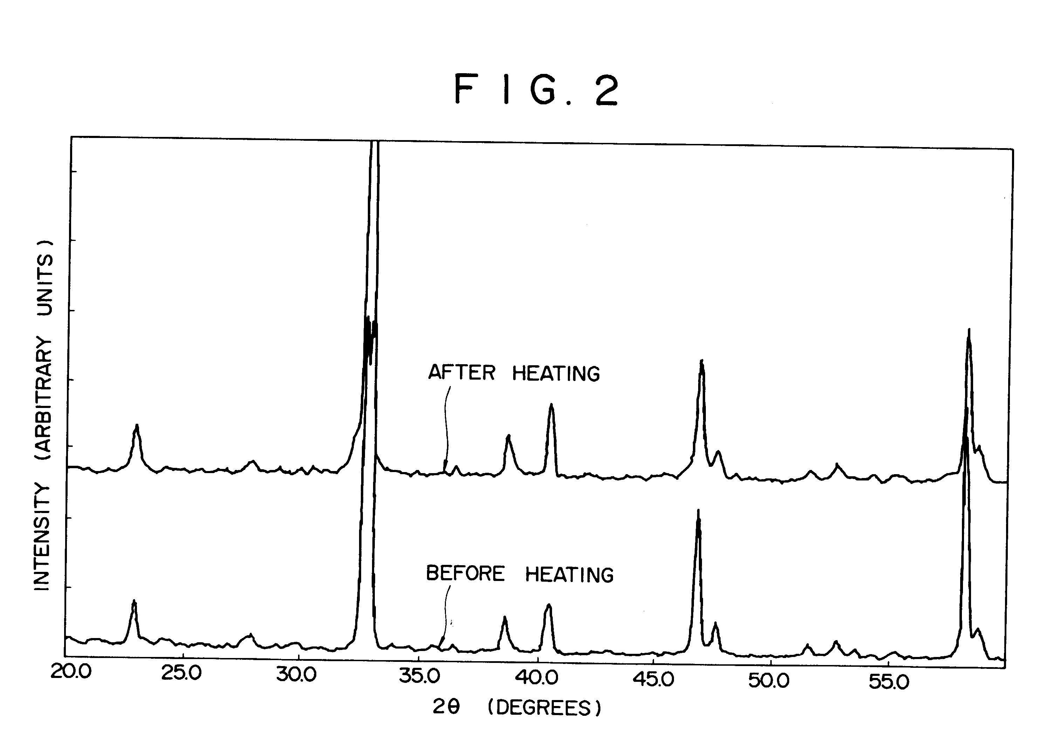

As an example of reactivity evaluation, FIG. 2 shows the results obtained when a powder mixture of YBa₂Cu₃O_{y} and a mixed crystal powder of La_{0.7}Nd_{0.3}GaO₃was heated at 900°C for one hour. FIG. 2 shows x-ray diffraction patterns of a powder mixture before and after heating at 900°C. Because the distribution of positions of diffraction peaks remained the same and no new peaks were observed before and after the heating, the La_{0.7}Nd_{0.3}GaO₃ mixed crystal powder and the YBa₂Cu₃O_{y} were found not to react with each other. Also, the similar results were obtained for mixed crystal powders with different compositions.

Also, Table 2 shows the lattice constants of each mixed crystal powder obtained by powder x-ray diffraction.

As shown in Table 2, compositions 3 and 4 are mixed crystals between compositions 1 and 2 and are composed of a single phase. Also, the values of the lattice constants of these compositions 3 and 4 fall between those of the above-mentioned compositions 1 and 2. Therefore, by selecting a suitable composition it is possible to set lattice constants at will in a range of 5.43 to 5.50Å for a, 5.50 to 5.53Å for b, and 7.72 to 7.78Å for c to suit a given purpose.

As clearly seen from Table 2 and the above-mentioned Table 1, the lattice constants of the substrate materials of embodiment 1 of the present invention are closer to the lattice constants of the oxide superconductors compared to the conventional substrate material.

As can be understood from what is described above, according to embodiment 1 of the present invention, the La sites in FIG. 3 mentioned above can be replaced by Nd having similar characteristics, but having a different ionic radius. Therefore, while maintaining the crystal structure, substrate materials with different lattice constants can be obtained. Thus the superconducting characteristics of an oxide superconductor can be improved by artificially changing lattice constants which are normally inherent to each material so as to reduce mismatching due to differences in the lattice constants of an oxide superconductor and a substrate material.

Having described the present invention as related to the embodiment, it should be noted that the present invention is by no means restricted by this embodiment. Variation and modification are possible within the scope of the present invention, as set out in the claims.

As we have described above, according to the substrate material for the preparation of an oxide superconductor of the present invention it is possible to improve the superconducting characteristics of an oxide superconductor prepared on the substrate material.

Also, according to the present invention a good semiconductor can be prepared on the substrate material.

In addition, according to the inventive preparation of an oxide superconductor on a semiconductor substrate with an intermediate layer there-between, it is possible to improve the superconducting characteristics of the above-mentioned oxide superconductors.

Furthermore, according to the inventive preparation of an oxide superconductor on a semiconductor substrate with an intermediate layer therebetween, a good semiconductor can be prepared on the intermediate layer.

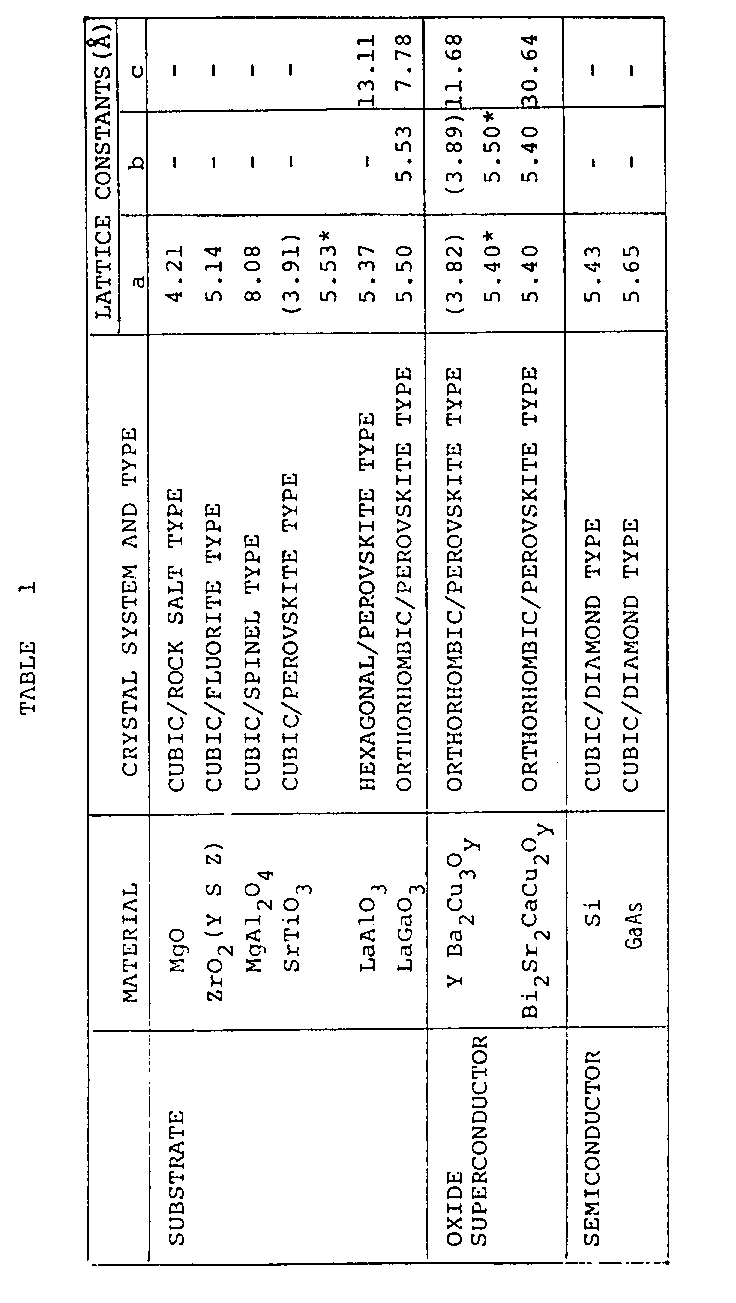

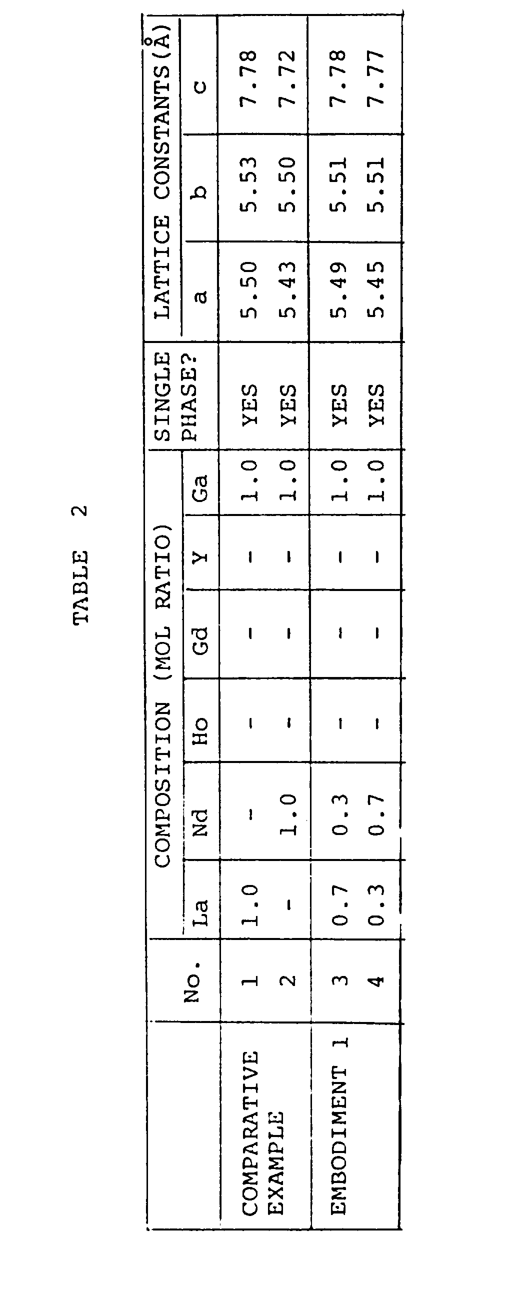

## Claims

1. A substrate material for preparing an oxide superconductor thereon,
characterized in that said substrate material is expressed by the chemical formula La₁₋ₓNdₓGaO₃ wherein x is equal to or more than 0.3 and less than 1.0 and which is a mixed crystal forming a perovskite-type structure having a composition of AGaO₃ where A is either Nd or La.

2. A substrate for preparing a semiconductor thereon,
characterized in that said substrate is the substrate material of claim 1.

3. A substrate for preparing an oxide superconductor thereon comprising a semiconductor substrate and an intermediate layer of a mixed crystal material formed on said semiconductor substrate,
characterized in that said mixed crystal material is the substrate material of claim 1.

4. A substrate for preparing a semiconductor thereon comprising an oxide superconductor substrate and an intermediate layer of a mixed crystal material formed on said oxide superconductor substrate,
characterized in that said mixed crystal material is the substrate material of claim 1.

## Patentansprüche

1. Substratmaterial zur Herstellung eines darauf befindlichen Oxidsupraleiters dadurch gekennzeichnet, daß das Substratmaterial durch die chemische Formel La₁₋ₓNdₓGaO₃ ausgedrückt wird, wobei x gleich oder mehr als 0,3 und weniger als 1,0 ist, und ein Mischkristall ist, das eine Struktur vom Perovskittyp der Zusammensetzung AGaO₃ ist, worin A entweder Nd oder La ist.

2. Substrat zur Herstellung eines hierauf befindlichen Halbleiters, dadurch gekennzeichnet, daß das Substrat das Substratmaterial des Anspruchs 1 ist.

3. Substrat zur Herstellung eines hierauf befindlichen Oxidsupraleiters, umfassend ein Halbleitersubstrat und eine Zwischenschicht aus einem auf dem Halbleitersubstrat gebildeten Mischkristallmaterial, dadurch gekennzeichnet, daß das Mischkristallmaterial das Substratmaterial des Anspruchs 1 ist.

4. Substrat zur Herstellung eines hierauf befindlichen Halbleiters, umfassend ein Oxidsupraleitersubstrat und eine Zwischenschicht aus einem auf dem Oxidsupraleitersubstrat gebildeten Mischkristall, dadurch gekennzeichnet, daß das Mischkristallmaterial das Substratmaterial des Anspruchs 1 ist.

## Revendications

1. Matière-substrat pour la préparation d'un oxyde supraconducteur sur ledit substrat, caractérisée en ce que ladite matière-substrat est exprimée par la formule chimique La₁₋ₓNdₓGaO₃ dans laquelle x est égal ou supérieur à 0,3 et inférieur à 1,0 et qui est un cristal mixte formant une structure de type perovskite ayant une composition de AGaO₃ où A est soit Nd, soit La.

2. Substrat pour la préparation d'un semiconducteur sur ledit substrat, caractérisé en ce que ledit substrat est une matière-substrat de la revendication 1.

3. Substrat pour la préparation d'un oxyde supraconducteur sur ledit substrat comprenant un substrat semiconducteur et une couche intermédiaire de matière cristalline mixte formée sur ledit substrat semiconducteur, caractérisé en ce que la matière cristalline mixte est la matière-substrat de la revendication 1.

4. Substrat pour la préparation d'un semiconducteur sur ledit substrat comprenant un substrat oxyde supraconducteur et une couche intermédiaire d'une matière cristalline mixte formée sur ledit substrat oxyde supraconducteur, caractérisé en ce que ladite matière cristalline mixte est la matière-substrat de la revendication 1.
